# EUROPÄISCHE PATENTSCHRIFT

(11) **EP 0 291 690 B1**
(45) Veröffentlichungstag und Bekanntmachung des Hinweises auf die Patenterteilung: **01.06.1994**
(21) Anmeldenummer: 88105914.1
(22) Anmeldetag: 14.04.1988
(51) Int. Cl.: H01L 21/68

(54) **Vorrichtung zum Ein-und Ausschleusen von Werkstücken in eine Beschichtungskammer**
Device for loading work pieces to and from a coating chamber
Dispositif pour entrer et sortir des pièces à traiter par un sas dans une chambre à dépôt

(30) Priorität: 16.05.1987 DE 3716498
(43) Veröffentlichungstag der Anmeldung: 23.11.1988
(73) Patentinhaber: LEYBOLD AKTIENGESELLSCHAFT, D-63450 Hanau (DE)
(72) Erfinder: Walde, Michael, D-6458 Rodenbach 1 (DE); Zejda, Jaroslav, D-6458 Rodenbach 1 (DE)

(56) Entgegenhaltungen:
- US-A- 3 915 117
- US-A- 4 548 699
- SOLID STATE TECHNOLOGY, Bd. 26, Nr. 7, Juli 1983, S. 115-123 ; F.T. Turner und D.J. Harra : "Advances in Cassette-to-Cassette Sputtercoating Systems".

## Beschreibung

Die Erfindung betrifft eine Beschichtungsvorrichtung mit Beschichtungskammer und Beschichtungsquelle und mit einer Einrichtung zum Ein- und Ausschleusen von Werkstücken in die evakuierbare, aus einem Deckel und einer sich zu diesem in einer parallelen Ebene erstreckenden Bodenplatte und einem beide Teile druckfest verbindenden und im Abstand zueinander haltenden ringförmigen Seitenteil gebildeten Beschichtungskammer und mit einem in der Beschichtungskammer rotierbar gelagerten Drehteller für den Transport der Werkstücke von einer Schleusenöffnung im Deckel zu der Beschichtungsquelle und zurück.

Es ist eine Vorrichtung der in Frage stehenden Art bekannt (US-A-3 874 525), die eine Beschichtungskammer aufweist, in der ein zweiarmiges Greifwerkzeug um eine vertikale Achse drehbar gelagert ist. Dieses zweiarmige Werkzeug weist an seinen einander diametral gegenüberliegenden Enden Gabeln auf, die mit Hilfe eines Zahnstangengetriebes mit Antriebsmotor in vertikaler Ebene gegenläufig zueinander bewegbar sind. Weiterhin sind zwei Konsolen in der Beschichtungskammer angebracht, von denen die eine unterhalb einer Schleuse im Deckel der Beschichtungskammer angeordnet ist und die andere auf der dieser Konsole gegenüberliegenden Seite unterhalb der Elektronenkanone.

Diese bekannte Vorrichtung hat den Nachteil, daß das zweiarmige Greifwerkzeug vergleichsweise aufwendig ausgebildet ist und auch wenig zuverlässig arbeitet, da der komplizierte Zahntrieb Abrieb erzeugt. Weiterhin besteht bei dieser Vorrichtung die Gefahr, daß das Werkstück nicht einwandfrei vom gabelförmigen Werkzeug erfaßt wird und dann entweder verkantet aufgenommen wird oder aber sich vollständig vom Werkzeug löst und dann auf die Bodenfläche der Beschichtungskammer fällt, was zwangsläufig zu einer Blockade bzw. zum Ausfall der gesamten Anlage führt. Schließlich benötigt die bekannte Vorrichtung eine große Bauhöhe, was eine unerwünscht voluminöse Beschichtungskammer erforderlich macht.

Bekannt ist auch eine Vakuumbeschichtungsanlage zum Aufdampfen dünner Schichten auf Substrate (US-A-3 915 117), mit einer Eintrittskammer, weiteren Kammern zur Behandlung bzw. Beschichtung der Substrate und mit einer Austrittskammer, sowie mit einer in einer evakuierbaren Hauptkammer angeordneten Fördereinrichtung zum Transport der Substrate durch die Kammern, wobei Abdichteinrichtungen zur zeitweisen Abdichtung zwischen den genannten Kammern und der Hauptkammer vorgesehen sind, wobei die Fördereinrichtung um eine gemeinsame Achse herum angeordnet und um diese schwenkbare Rahmen für die Aufnahme des zu beschichtenden Gutes aufwiest, wobei in wenigstens zwei Behandlungspositionen, nämlich einer Ein- und Austrittsposition und einer Aufdampfposition, ein solcher Rahmen selbst Teil der Wand einer Behandlungskammer, nämlich der Ein- und Austrittskammer und einer Aufdampfkammer bildet und wobei in mindestens einer dieser Behandlungspositionen eine bewegbare Ventilplatte zum Absperren einer Stirnseite des den einen Teil der Behandlungskammer bildenden Rahmens vorgesehen ist.

Diese bekannte Vakuumbeschichtungsanlage hat den Nachteil, daß in zwei Behandlungspostionen der Rahmen selbst Teil der Wand einer Behandlungskammer bildet, so daß ein Druckausgleich des Raumes vor der Beschichtungsquelle mit der Hauptkammer nicht stattfindet. Darüberhinaus ist ein besonderer Deckel mit Betätigungseinrichtung erforderlich, der lediglich dem Verschließen der Einschleuskammer dient und der ansonsten keine Funktion im Hinblick auf das Zu- und Abführen der Substrate hat.

Bekannt ist auch eine Vorrichtung der in Frage stehenden Art (US-A-4 548 699), bei der eine etwa kreiszylindrische Beschichtungskammer vorgesehen ist, bestehend aus einem kreisscheibenförmigen Deckel und einer eben solchen Bodenplatte, wobei Deckel und Bodenplatte mit einem hohlzylindrischen bzw. ringförmigen Seitenteil fest verbunden sind und bei der in der Beschichtungskammer ein kreisscheibenförmiger Drehteller zur Halterung und Führung der Substrate und eine weitere Druckplatte angeordnet sind, die im übrigen in Richtung auf den Deckel zu verschiebbar sind und nach dem Verschieben zusammen mit dem Deckel eine im Deckel vorgesehene Einschleusöffnung druckfest verschließen. Diese bekannte Vorrichtung weist einen komplizierten Aufbau auf und arbeitet relativ langsam, insbesondere da die Wafer von federnden Elementen übernommen werden müssen und die Einschleusöffnung durch eine zusätzliche Verschlußplatte, die um einen sich quer zur Rotationsachse angeordneten Bolzen schwenkt, verschlossen werden muß.

Der Erfindung liegt deshalb die Aufgabe zugrunde, eine Vorrichtung zu schaffen, die die Nachteile der bekannten Vorrichtungen nicht aufweist, die sich gegenüber bekannten Vorrichtungen durch größere Zuverlässigkeit auszeichnet, die mit einer höheren Taktzeit arbeitet, deren Beschichtungskammer besonders kleinvolumig ist und die insbesondere auch für besonders empfindliche, dünnwandige und aus nachgiebigem Werkstoff gefertigte Werkstücke, beispielsweise sogenannte Wafer, geeignet ist.

Diese Aufgabe wird erfindungsgemäß durch eine Beschichtungsvorrichtung nach Anspruch 1 gelöst. Sie enthält insbesondere eine Beschikkungseinrichtung mit einem oder mehreren deckelförmigen Werkstückträgern, mit Hilfe derer die unterhalb der Werkstückträger gehaltenen Werkstücke in eine der Schleusenöffnung der Beschichtungskammer benachbarte Position bringbar sind, von der aus die Schleusenöffnung von oben her vom Werkstückträger und von unten her vom Hubteller verschließbar ist, der auf dem rotierbar gelagerten Drehteller gehalten und geführt ist, wobei der Werkstückträger von einem sich an der Beschikkungsvorrichtung abstützenden Hubzylinder und der Hubteller von einer ortsfesten Hubvorrichtung an den Deckel anpreßbar sind, wobei die beidseitig verschlossene Schleusenöffnung zum Ein- und Ausschleusen evakuierbar ist.

Mit Vorteil weist die Schleusenöffnung im Deckel der Beschichtungskammer einen Abstand von der Rotationsachse des Drehtellers auf, der dem Abstand von der Rotationsachse zu einer weiteren Öffnung im Deckel der Beschichtungskammer entspricht, oberhalb der die Beschichtungsquelle angeordnet ist.

Zweckmäßigerweise ist die Schleusenöffnung im Deckel der Beschichtungskammer von einem fest am Deckel angeordneten Einschleusring begrenzt, der eine Stufenbohrung aufweist, deren große Stufe auf der dem Werkstückträger zugekehrten Seite vorgesehen ist, wobei der Werkstückträger eine flanschförmige, umlaufende Randpartie aufweist, die so bemessen ist, daß sie zum Verschließen der Schleusenöffnung auf die Stufe des Einschleusrings aufsetzbar ist.

Um eine zuverlässige Trennung des Werkstücks vom Werkstückträger beim Einschleusen zu bewirken und um ein Minimum an Vakuumverlust zu ermöglichen, weist der fest am Deckel der Beschichtungskammer angeordnete Einschleusring einen oder mehrere sich radial erstreckende Kanäle auf, die mit weiteren Durchlässen oder Bohrungen korrespondieren, die mit einer Pumpensaugleitung oder einem Pumpenanschluß verbunden sind, wobei die Kanäle in einen Bereich der Schleusenöffnung des Einschleusrings einmünden, der bei auf den Einschleusring aufgesetztem Werkstückträger und angepreßtem Hubteller von einem vom Werkstückträger und Hubteller gebildeten Zwischenraum oder Spalt gebildet wird.

Vorzugsweise ist die Beschickungsvorrichtung mit einem auf der Oberseite des Deckels der Beschichtungskammer fest angeordneten Schwenkmotor versehen, dessen Antriebswelle mit einem sich quer zur Abtriebswelle erstreckenden Schwenkarm drehfest verbunden ist, wobei an mindestens einem Schwenkarmende ein Hubmotor oder Hubzylinder angeordnet ist, dessen Arbeitswelle oder Kolbenstange sich lotrecht zur Ebene der Beschichtungskammer erstreckt und mit dem Werkstückträger in Wirkverbindung steht.

Die an der Bodenplatte der Beschichtungskammer angeordnete Hubvorrichtung besteht mit Vorteil aus einem magnetisch, hydraulisch oder pneumatisch betriebenen Motor, der eine Kolbenstange oder einen Stößel antreibt, der dichtend durch die Bodenplatte hindurchgeführt ist und der während seines Ausfahrhubs auf einen Zapfen einwirkt, der Teil des in eine Ausnehmung des Drehtellers absenkbaren Hubtellers ist.

Um eine sichere und rasche Zuführung des Werkstücks zum und von der Einschleusstation innerhalb der Beschichtungskammer sicherzustellen, sind die Oberseite und die Unterseite des Drehtellers zueinander planparallel ausgebildet und erstrecken sich im Abstand zur planen Innenfläche des Deckels bzw. der Bodenplatte, wobei zwischen Drehteller und Deckel eine sich quer zur Rotationsachse des Drehtellers erstreckende Quer- oder Dichtleiste, deren Dicke etwa dem Abstand zwischen dem Deckel und der Oberseite des Drehtellers entspricht, an der Innenfläche des Deckels ortsfest angeordnet ist, die den zwischen Drehteller und Deckel verbleibenden spaltförmigen Raum in zwei kreissektorenförmige Abschnitte aufteilt und ein Überströmen von Gasen vom einen zum anderen Abschnitt weitgehend ausschließt.

Weitere Einzelheiten und Merkmale sind in den Unteransprüchen näher beschrieben und gekennzeichnet.

Die Erfindung läßt die verschiedensten Ausführungsmöglichkeiten zu; eine davon ist in den anhängenden Zeichnungen näher dargestellt, und zwar zeigen:
- Figur 1: eine Vorrichtung zum Beschichten von scheibenförmigen Werkstücken (Wafern) in der Seitenansicht, bestehend im wesentlichen aus dem Maschinengestell, dem elektrischen Steuerschrank, der Kathodenkammer, der Beschichtungskammer, der Beschickungsvorrichtung und dem Schwenkarm,
- Figur 2: einen Teil der Vorrichtung gemäß Figur 1 in der Draufsicht,
- Figur 3: die Beschickungsvorrichtung gemäß Figur 1, teilweise im Schnitt und in vergrößerter Darstellung,
- Figur 4: das Unterteil der Kathodenkammer gemäß Figur 1, im Schnitt und in vergrößerter Darstellung, wobei Teile der Beschichtungskammer mit strichlierten Linien dargestellt sind,
- Figur 5: den Längsschnitt durch den Drehteller der Beschichtungskammer,
- Figur 6: die Hubvorrichtung zum Anheben der scheibenförmigen Werkstücke (der Wafer) und
- Figur 7: den Einschleusring im Längsschnitt.

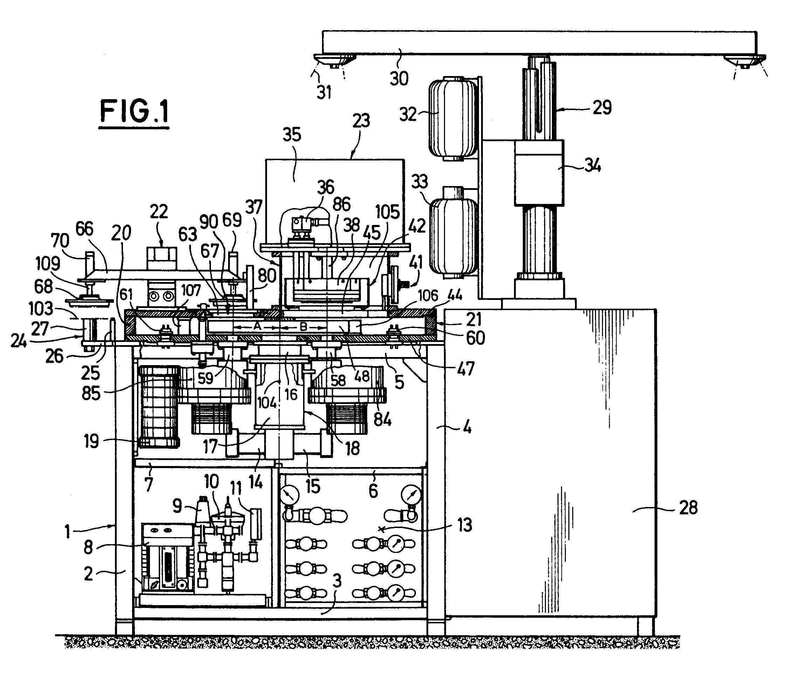

Wie Figur 1 zeigt, ist das kastenförmige Maschinengestell aus mehreren Streben 2 bis 7 zusammengefügt, wobei auf den unteren Streben 3 eine Vakuumpumpe 8 mit der aus einer Meßröhre 9, einem Lufteinlaßfilter 10 und einem Druckschalter 11 bestehenden Vakuumsteuereinheit 12 und eine Wasserbatterie 13 gehalten sind.

Auf den von den Streben 6, 7 gebildeten mittleren Rahmen ist der aus den beiden pneumatischen Antriebseinheiten 14, 15, der Konsole 16 und dem Torsionsdämpfer 17 bestehende Schwenkmotor 18 abgestützt. An den sich vertikal erstreckenden Streben 2 ist ein Ventilblock 19 für die Versorgung verschiedener Aggregate mit Druckluft angeordnet.

Der aus den Streben 5 gebildete obere Rahmen trägt die insgesamt mit 21 bezeichnete und im wesentlichen aus dem Seitenteil 20, dem Deckel 44 und der Bodenplatte 47 bestehende Beschichtungskammer, auf deren Oberseite die Beschickungsvorrichtung 22 und die Kathodenkammer 23 angeordnet sind.

Der Beschickungsvorrichtung 22 ist die Werkstückzuführung 24 zugeordnet, die im dargestellten Ausführungsbeispiel aus einem Haltearm 26 mit Haltedorn 27 und einer Lichtschranke 25 besteht - jedoch ebenso auch aus einem Transportband oder einer selbsttätig arbeitenden Vorrichtung gebildet sein kann.

Neben dem Maschinengestell 1 ist ein Steuerschrank 28 angeordnet, der die im einzelnen nicht näher dargestellten elektrischen Steuerelemente aufnimmt. Auf der Oberseite des Steuerschranks 28 ist das sich lotrecht erstreckende Lagerrohr 29 eines schwenkbaren und in seiner Höhe verstellbaren Kranarms 30 zusammen mit dem Gehänge 31 und den Druckluftspeichern 32, 33, dem Druckluftmotor 34 für den Antrieb des Kranarms 30 vorgesehen.

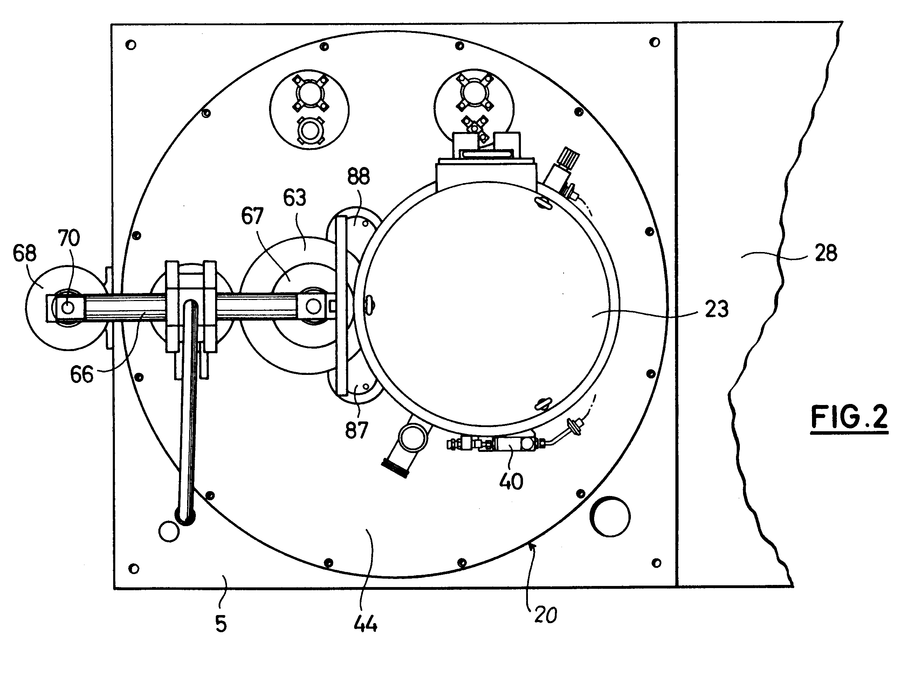

Die Kathodenkammer 23 besteht aus einem Oberteil 35 zur Aufnahme des Kühlmittelzulaufs und des -ablaufs 36 und den nicht dargestellten elektrischen Anschlüssen. Im Unterteil 37 der Kathodenkammer 23 ist die Kathode 38 mit dem Target 39 gehalten. Am Unterteil 37 sind weiterhin eine Vorrichtung 40 zur geregelten Einspeisung von Gas (Figur 2) und eine Wasserarmatur 41 (Figur 1) vorgesehen.

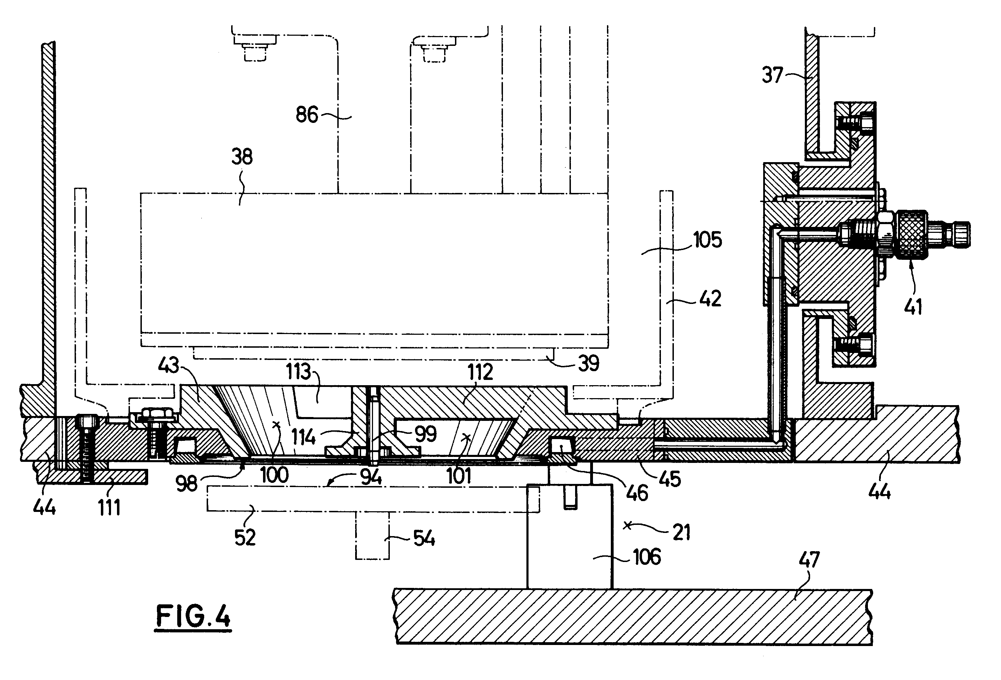

Die Kathode 38, die als eine für das PVD-Verfahren (Physical Vapor Deposition) geeignete Beschichtungsquelle ausgebildet ist, ist teilweise von einer Blende 42 umschlossen (Figur 4) und nach unten hin durch eine Maske 43 von der Beschichtungskammer 21 abgetrennt. Die Maske 43 ist - zusammen mit der Blende 42 - auf einem Arm 112 der Beschichtungskammer 21 gehalten und auf den Abstandhaltern 106 der Bodenplatte 47 abgestützt, wobei der die Maske 43 und die Blende 42 tragende Flansch 45 von Kühlkanälen 46 durchzogen ist.

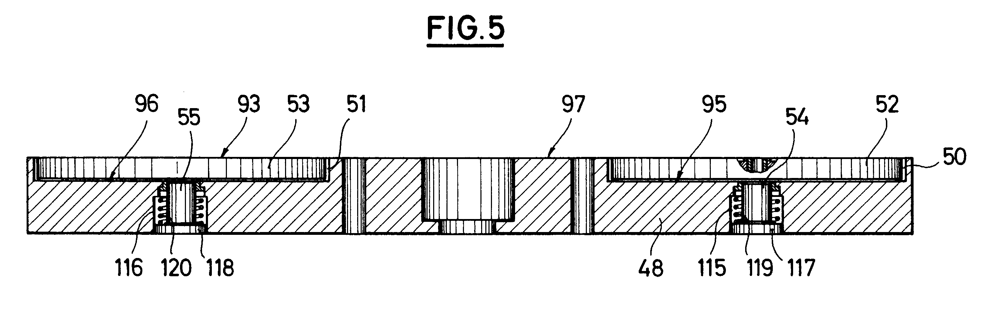

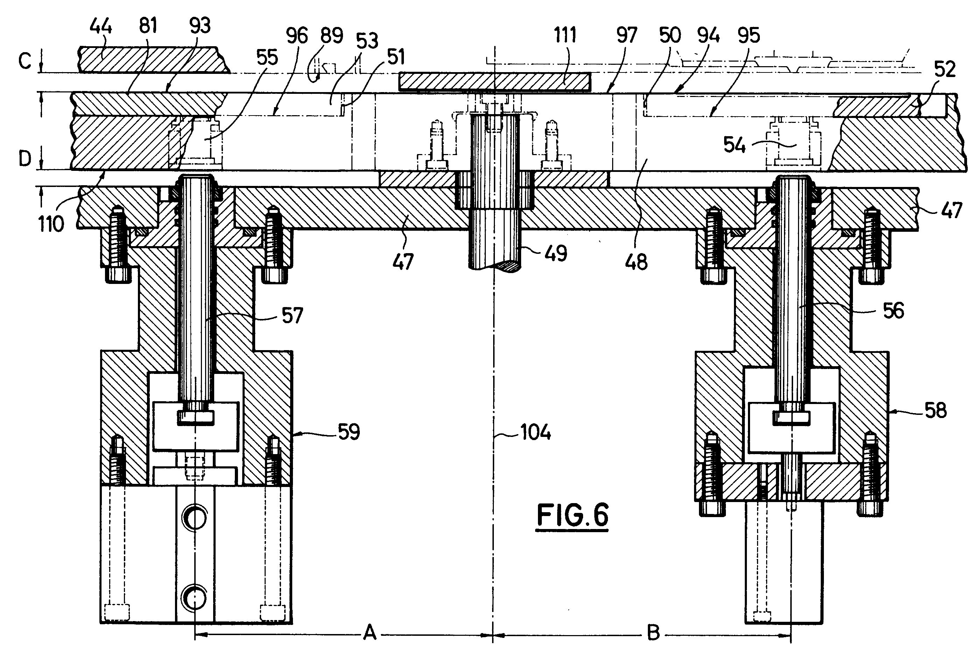

In der Beschichtungskammer 21 ist zwischen dem Deckel 44 und der Bodenplatte 47 der Drehteller 48 drehbar auf der Welle 49 des Schwenkmotors 18 angeordnet. Der Drehteller 48 (Figur 5) ist auf seiner Oberseite mit Ausnehmungen 50, 51 zur Halterung von Hubtellern 52, 53 versehen, die (Figur 6) über Zapfen 54, 55 mit den Stößeln 56, 57 der an der Bodenplatte 47 angebrachten Hubvorrichtungen 58, 59 korrespondieren.

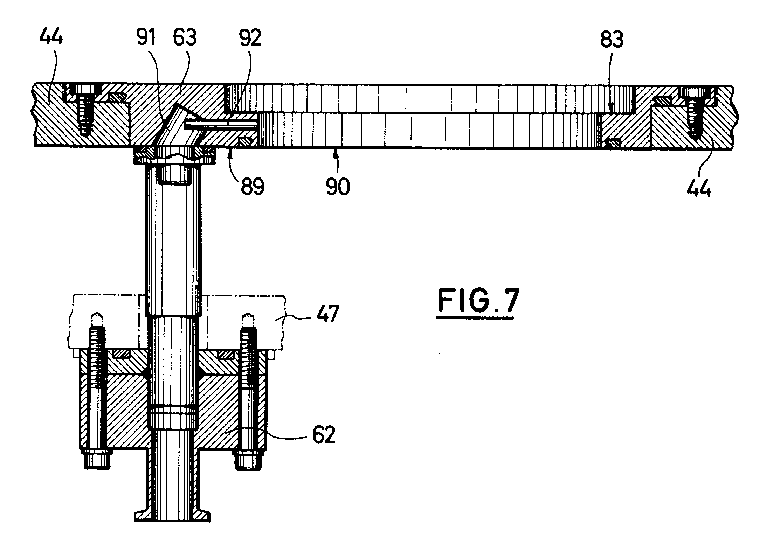

Die Bodenplatte 47 der Beschichtungskammer 21 weist außerdem Lichtleiterdurchführungen 60, 61 und einen Vakuumpumpenanschluß 62 auf, der in Figur 7 - zusammen mit dem Einschleusring 63, der seinerseits am Deckel 44 befestigt ist - näher dargestellt ist. Schließlich trägt die Bodenplatte 47 noch die beiden Vakuumpumpen 84, 85.

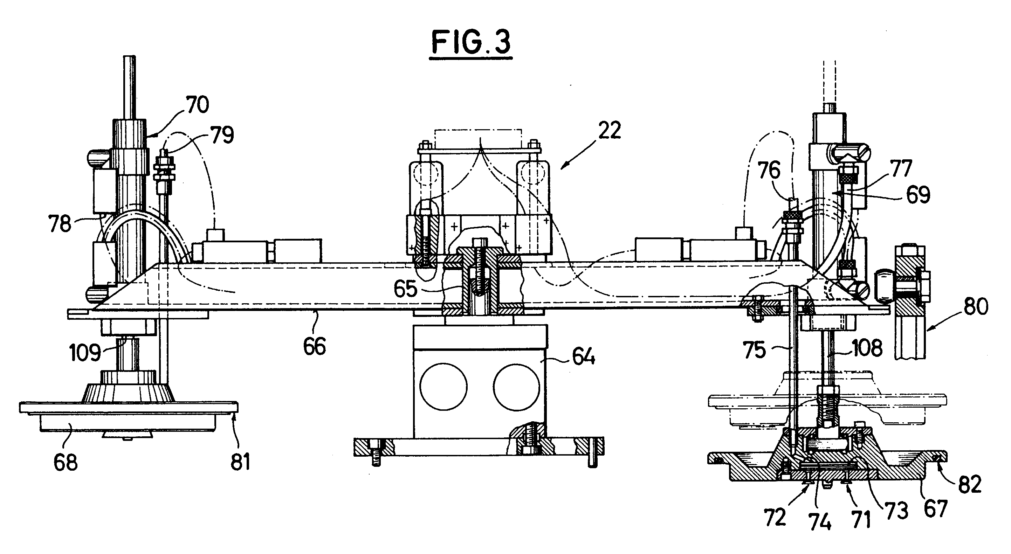

Die auf dem Deckel 44 angeordnete Beschickungsvorrichtung 22 ist in Figur 3 näher dargestellt und besteht aus einem Schwenkmotor 64 mit Welle 65, einem Schwenkarm 66, den beiden Werkstückträgern 67, 68 und den pneumatisch angetriebenen, über Schlauchleitungen 77, 78 mit dem Ventilblock 19 verbundenen Hubzylindern 69, 70.

Jeder der beiden Werkstückträger 67, 68 ist mit Saugdüsen 71, 72 ausgestattet, die über eine Kammer 73, einen Kanal 74 und ein Anschlußrohr 75 mit Schlauchleitung 76 bzw. 79 an dem Ventilblock 19 angeschlossen sind. Auf dem Deckel 44 der Beschichtungskammer 21 ist schließlich noch eine Lichtschranke 8 befestigt, die die Stellung der Werkstückträger 67, 68 sensiert.

Die Beschickungsvorrichtung 22 arbeitet wie folgt: Sobald auf dem Haltdorn 27 der Werkstückzuführung 24 ein Werkstück 103 (beispielsweise ein kreisscheibenförmiger Kunststoffträger, ein sogenanntes Substrat oder ein Wafer) aufgelegt ist, gibt die Lichtschranke 25 ein elektrisches Signal an die nicht näher dargestellte elektrische Steuereinheit, die ihrerseits den Hubzylinder aktiviert, der den Werkstückträger 68 bis auf das Werkstück 103 absenkt (untere Position), wo die Saugeinrichtung 71 bis 74 das Werkstück 103 übernimmt.

Anschließend fährt der Werkstückträger 67 - zusammen mit dem Werkstück 103 - wieder in die obere Position, und es erfolgt eine Schwenkbewegung des vom Schwenkmotor 64 angetriebenen Schwenkarms 66, so daß dieser Werkstückträger 68 eine der Kathode 38 zugewandte zweite Position einnimmt.

Nach Erreichen dieser zweiten Position bewegt der Hubzylinder 70 den jeweiligen Werkstückträger 68 bzw. 67 so weit nach unten zu, bis der Werkstückträger (Figur 3 zeigt diese Position am abgesenkten Werkstückträger 67) mit seinem umlaufenden Rand 81 bzw. 82 auf der Stufe 83 des Einschleusrings 63 direkt aufliegt (Figur 7). Während dieser Phase ist der Hubteller 53 in seiner oberen Position, in der er vom Stößel 57 der Hubvorrichtung 59 von unter her direkt gegen die Unterseite 89 des Einschleusrings 63 gepreßt wird und die Schleusenöffnung 90 verschlossen hält.

Dadurch, daß über den Vakuumpumpenanschluß 62 und die mit diesem korrespondierenden Bohrungen 91, 92 die Luft im Spalt zwischen der Oberseite 91 des Hubtellers 53 und der Unterseite des Werkstückträgers 68 abgesogen wird, stellt sich sofort nach dem Absenken des Werkstückträgers 68 ein Vakuum ein, so daß sich das scheibenförmige Werkstück 103 vom Werkstückträger 68 trennt und auf der vertieften Oberseite des Hubtellers 53 ablagert.

In einem nächsten Arbeitstakt wird nun der Hubteller 53 über die pneumatische Hubvorrichtung 59 so weit abgesenkt, daß der Hubteller 53 auf der Bodenoberfläche 96 der Ausnehmung 51 aufliegt, wobei die Oberseite des Hubtellers 53 genau mit der Oberseite 97 des Drehtellers 48 abschließt.

Nachdem der Stößel 57 der Hubvorrichtung 59 die innere Position eingenommen hat (wie dies in Figur 6 dargestellt ist), tritt der Schwenkmotor 18 in Tätigkeit und schwenkt die in Figur 6 auf der linken Bildseite dargestellte Partie des Drehtellers 48 in die rechte Position, d. h. so weit, daß der Zapfen 55 des Drehtellers 48 mit dem Stößel 56 fluchtet.

In dieser Position kann nun die Hubvorrichtung 58 über den Stößel 56 und den Zapfen 55 den Hubteller 53 aufwärts bewegen, bis das Werkstück 103, das auf dem Hubteller 53 aufliegt, an der Unterseite 89 der Maske 43 anliegt, wobei der Stift 99 das mit einer Zentrierbohrung versehene Werkstück 103 (nicht näher dargestellt) genau positioniert.

Im nächsten Arbeitsschritt wird das Werkstück 103 über das Target 39 besputtert (d. h. beschichtet), wobei die scheibenförmige, mit Durchbrüchen 100 und Ausnehmungen 101 versehene Maske 43 und die Blende 42 (Figur 4) eine unerwünschte Beschichtung der Innenfläche des Unterteils 37 der Kathodenkammer 23 und des Drehtellers 48 verhindern.

In einem folgenden Arbeitstakt wird nun (nach erfolgter Beschichtung des Werkstücks 103) der Hubteller 53 wieder abgesenkt (wie dies in Figur 4 am Beispiel des Hubtellers 52 mit strichlierten Linien angedeutet ist) und anschließend durch Schwenken des Drehtellers 48 um 180° in die in Figur 6 dargestellte Position gebracht.

Mit Hilfe der Hubvorrichtung 59 kann jetzt der Hubteller 53 so weit angehoben werden, bis er fest an der Unterseite 89 des Einschleusrings 63 anliegt. Die Absaugung des Spalts zwischen dem die Einschleusöffnung 90 von oben her verschließenden Werkstückträger 68 und dem von unten her gegen den Einschleusring 63 gepreßten Hubteller 53 wird nun abgeschaltet, damit die in Figur 3 am Beispiel des Werkstückträgers 67 gezeigten Saugdüsen 71, 72 bzw. Saugnäpfe das Werkstück 103 aufnehmen können und der Werkstückträger 68 anschließend vom Hubzylinder 70 angehoben und in seine Ausgangsposition verschwenkt werden kann (wie dies in den Figuren 1 und 3 dargestellt ist), in der der Hubzylinder 70 das Werkstück 103 wieder auf den Haltedorn 27 ablegen kann.

Die vorstehend am Beispiel des Werkstückträgers 68 beschriebene Wirkungsweise gilt sinngemäß auch für den Werkstückträger 67, wobei die anhängenden Zeichnungen klar erkennen lassen, daß sich während des Betriebs abwechselnd immer der eine oder der andere Werkstückträger 67 bzw. 68 über dem Haltedorn 27 bzw. dem Einschleusring 63 befindet. Ebenso ergibt sich aus den Zeichnungen, daß in einem zur Bewegung des Schwenkarms 66 synchronen Arbeitstakt sich auch der Drehteller 48 von der einen in die andere Position bewegt.

### Bezugszeichenliste

- 1: Maschinengestell
- 2: Strebe
- 3: Strebe
- 4: Strebe
- 5: Strebe
- 6: Strebe
- 7: Strebe
- 8: Vakuumpumpe
- 9: Meßröhre
- 10: Lufteinlaßfilter
- 11: Druckschalter
- 12: Vakuumsteuereinheit
- 13: Wasserbatterie
- 14: pneumatische Antriebseinheit
- 15: pneumatische Antriebseinheit
- 16: Konsole
- 17: Torsionsdämpfer
- 18: Schwenkmotor
- 19: Ventilblock
- 20: Seitenteil
- 21: Beschichtungskammer
- 22: Beschickungsvorrichtung
- 23: Kathodenkammer, Kathodenstation
- 24: Werkstückzuführung
- 25: Lichtschranke
- 26: Haltearm
- 27: Haltedorn
- 28: Steuerschrank
- 29: Lagerrohr
- 30: Kranarm
- 31: Gehänge
- 32: Druckluftspeicher
- 33: Druckluftspeicher
- 34: Druckluftmotor
- 35: Oberteil
- 36: Kühlmittelzulauf und -ablauf
- 37: Unterteil
- 38: Kathode, Beschichtungsquelle
- 39: Target
- 40: Vorrichtung zur Gaseinspeisung
- 41: Wasserarmatur
- 42: Blende
- 43: Maske
- 44: Deckel
- 45: Flansch
- 46: Kühlkanal
- 47: Bodenplatte
- 48: Drehteller
- 49: Welle
- 50: Ausnehmung
- 51: Ausnehmung
- 52: Hubteller
- 53: Hubteller
- 54: Zapfen
- 55: Zapfen
- 56: Stößel
- 57: Stößel
- 58: Hubeinrichtung
- 59: Hubeinrichtung
- 60: Lichtleiterdurchführung
- 61: Lichtleiterdurchführung
- 62: Vakuumpumpenanschluß
- 63: Einschleusring
- 64: Schwenkmotor
- 65: Welle
- 66: Schwenkarm
- 67: Werkstückträger
- 68: Werkstückträger
- 69: Hubzylinder
- 70: Hubzylinder
- 71: Saugdüse
- 72: Saugdüse
- 73: Kammer
- 74: Kanal
- 75: Anschlußrohr
- 76: Schlauchleitung
- 77: Schlauchleitung
- 78: Schlauchleitung
- 79: Schlauchleitung
- 80: Lichtschranke
- 81: umlaufender Rand
- 82: umlaufender Rand
- 83: Stufe
- 84: Vakuumpumpe
- 85: Vakuumpumpe
- 86: Kathodenhalter
- 87: Blindstützen
- 88: Blindstützen
- 89: Unterseite des Einschleusrings
- 90: Öffnung, Einschleusöffnung, Schleusenöffnung
- 91: Bohrung
- 92: Bohrung
- 93: Oberseite
- 94: Oberseite
- 95: Bodenfläche
- 96: Bodenfläche
- 97: Oberseite des Drehtellers
- 98: Unterseite der Maske
- 99: Zentrierstift
- 100: Durchbruch, Ausdehnung
- 101: Durchbruch, Ausdehnung
- 102: Steg
- 103: Werkstück
- 104: Rotationsachse des Drehtellers
- 105: Kathodenkammer
- 106: Abstandhalter
- 107: Abstandhalter
- 108: Kolbenstange
- 109: Kolbenstange
- 110: Unterseite
- 111: Dichtleiste
- 112: Arm
- 113: Arm
- 114: Mittelabschnitt
- 115: Bohrung
- 116: Bohrung
- 117: Kragen
- 118: Kragen
- 119: Druckfeder
- 120: Druckfeder

## Patentansprüche

1. Beschichtungsvorrichtung mit Beschichtungskammer (21) und einer Kathode als Beschichtungsquelle (38),mit einer Einrichtung zum Ein- und Ausschleusen von im wesentlichen flachen Werkstücken (103) in die evakuierbare, aus einem Deckel (44) und einer sich zu diesem in einer parallelen Ebene erstreckenden Bodenplatte (47) und einem beide Teile (44, 47) druckfest verbindenden und im Abstand zueinander haltenden ringförmigen Seitenteil (20) gebildeten Beschichtungskammer (21) und mit einem in der Beschichtungskammer (21) rotierbar gelagerten Drehteller (48) für den Transport der Werkstücke (103) von einer Schleusenöffnung (90) im Deckel (44) der Beschichtungskammer (21) zu der Beschichtungsquelle (38) und zurück, **gekennzeichnet durch** eine Beschickungsvorrichtung (22) mit einem oder mehreren deckelförmigen Werkstückträgern (67, 68), mit Hilfe derer die unterhalb der Werkstückträger (67,68) gehaltenen Werkstücke (103) in eine der Schleusenöffnung (90) der Beschichtungskammer (21) benachbarte Position bringbar sind, von der aus die Schleusenöffnung (90) von oben her mittels des Werkstückträgers (67, 68) und von unten her mittels eines Hubtellers (52, 53) verschließbar ist, wobei Hubteller der auf dem rotierbar gelagerten Drehteller (48) gehalten und geführt ist und wobei der Werkstückträger (67, 68) mittels eines sich an der Beschickungsvorrichtung (22) abstützenden Hubzylinder (69, 70) und der Hubteller (52, 53) mittels einer ortsfesten Hubvorrichtung (58, 59) an den Deckel (44) anpreßbar sind, wobei die beidseitig verschlossene Schleusenöffnung (90) zum Ein- und Ausschleusen evakuierbar ist.

2. Vorrichtung nach Anspruch 1, **dadurch gekennzeichnet,** daß die Schleusenöffnung (90) im Deckel (44) der Beschichtungskammer (21) einen Abstand (A) von der Rotationsachse (104) des Drehtellers (48) aufweist, der dem Abstand (B) von der Rotationsachse (104) zu einer weiteren Öffnung im Deckel (44) der Beschichtungskammer (21) entspricht, oberhalb derer die Beschichtungsquelle (38) angeordnet ist.

3. Vorrichtung nach den Ansprüchen 1 und 2, **dadurch gekennzeichnet,** daß die Schleusenöffnung (90) im Deckel (44) der Beschichtungskammer (21) von einem fest am Deckel (44) angeordneten Einschleusring (63) begrenzt ist, der eine Stufenbohrung aufweist, deren große Stufe (83) auf der dem Werkstückträger (67, 68) zugekehrten Seite vorgesehen ist, wobei der Werkstückträger (67, 68) eine flanschförmige, umlaufende Randpartie (81, 82) aufweist, die so bemessen ist, daß sie zum Verschließen der Schleusenöffnung (90) auf die Stufe (83) des Einschleusrings (63) aufsetzbar ist.

4. Vorrichtung nach den vorhergehenden Ansprüchen, **dadurch gekennzeichnet,** daß der fest am Deckel (44) der Beschichtungskammer (21) angeordnete Einschleusring (63) einen oder mehrere sich radial erstreckende Kanäle (92) aufweist, die mit weiteren Durchlässen oder Bohrungen (91) korrespondieren, die mit einer Pumpensaugleitung oder einem Pumpenanschluß (62) verbunden sind, wobei die Kanäle (92) in einen Bereich der Schleusenöffnung (90) des Einschleusrings (63) einmünden, der bei auf den Einschleusring (63) aufgesetztem Werkstückträger (67, 68) und angepreßten Hubteller (52, 53) von einem vom Werkstückträger und angepreßtem Hubteller gebildeten Zwischenraum oder Spalt gebildet wird.

5. Vorrichtung nach einem oder mehreren der vorhergehenden Ansprüche, **dadurch gekennzeichnet,** daß die Beschickungsvorrichtung (22) einen auf der Oberseite des Deckels (44) der Beschichtungskammer (21) fest angeordneten Schwenkmotor (64) aufweist, dessen Abtriebswelle (65) mit einem sich quer zur Abtriebswelle (65) erstreckenden Schwenkarm (66) drehfest verbunden ist, wobei an mindestens einem Schwenkarmende ein Hubmotor oder Hubzylinder (69, 70) angeordnet ist, dessen Arbeitswelle oder Kolbenstange (108, 109) sich lotrecht zur Ebene der Beschichtungskammer (21) erstreckt und mit dem Werkstückträger (67, 68) in Wirkverbindung steht.

6. Vorrichtung nach einem oder mehreren der vorhergehenden Ansprüche, **dadurch gekennzeichnet,** daß die an der Bodenplatte (47) der Beschichtungskammer (21) angeordnete Hubvorrichtung (58, 59) aus einem magnetisch, hydraulisch oder pneumatisch betriebenen Motor besteht, der eine Kolbenstange oder einen Stößel (56, 57) antreibt, der dichtend durch die Bodenplatte (47) hindurchgeführt ist und der während seines Ausfahrhubs auf einen Zapfen (54, 55) einwirkt, der Teil des in eine Ausnehmung (50, 51) des Drehtellers (48) absenkbaren Hubtellers (52, 53) ist.

7. Vorrichtung nach einem oder mehreren der vorhergehenden Ansprüche, **dadurch gekennzeichnet,** daß die Oberseite (97) und die Unterseite (110) des Drehtellers (48) zueinander planparallel ausgebildet und sich im Abstand (C, D) zur planen Innenfläche des Deckels (44) bzw. der Bodenplatte (47) erstrecken, wobei zwischen Drehteller (48) und Deckel (44) eine sich quer zur Rotationsachse (104) des Drehtellers (48) erstreckende Quer- oder Dichtleiste (111), deren Dicke etwa dem Abstand (C) zwischen dem Deckel (44) und der Oberseite (97) des Drehtellers (48) entspricht, an der Innenfläche des Deckels (44) ortsfest angeordnet ist, die den zwischen Drehteller (48) und Deckel (44) verbleibenden spaltförmigen Raum in zwei kreissektorenförmige Abschnitte aufteilt und ein Überströmen von Gasen vom einen zum anderen Abschnitt weitgehend ausschließt.

8. Vorrichtung nach einem oder mehreren der vorhergehenden Ansprüche, **dadurch gekennzeichnet,** daß im Bereich einer die Kathode enthaltenden Kathodenkammer (23) zwischen einem Target (39) und dem Drehteller (48) im Deckel (44) der Beschichtungskammer (21) eine Öffnung vorgesehen ist, in die ein mit Kühlkanälen (46) durchzogener Ring oder Flansch (45) eingesetzt ist, auf dem eine kragenförmige Maske (43) fest angeordnet ist, wobei die Maske (43) einen oder mehrere sich radial nach innen zu erstreckende Arme (112, 113) aufweist, die einen gemeinsamen Mittelabschnitt (114) bilden, der einen sich in Richtung auf den Drehteller (48) zu erstreckenden Zentrierstift (99) hält.

9. Vorrichtung nach Anspruch 8, **dadurch gekennzeichnet,** daß der zwischen dem Target (39) und dem Drehteller (49) in den Deckel (44) der Beschichtungskammer (21) eingesetzte Ring oder Flansch (45) eine Blende (42) aufweist, die weitgehend als Hohlzylinder ausgebildet ist und die Beschichtungsquelle (38) zumindest teilweise umschließt.

10. Vorrichtung nach Anspruch 8 oder 9 in Verbindung mit Anspruch 7, **dadurch gekennzeichnet,** daß der in dem Deckel (44) der Beschichtungskammer (21) eingesetzte Flansch (45) an der zwischen dem Drehteller (48) und dem Deckel (44) angeordneten Dichtleiste (111) abgestützt oder mit dieser verschraubt ist.

11. Vorrichtung nach einem oder mehreren der Ansprüche 8-10, **dadurch gekennzeichnet,** daß zwischen dem Deckel (44) und der Bodenplatte (47) ein oder mehrere Abstandshalter (106, 107) angeordnet sind, wobei der in den Deckel (44) eingesetzte Flansch (45) von mindestens einem dieser Abstandshalter (106, 107) abgestützt und gehalten ist.

12. Vorrichtung nach einem oder mehreren der vorhergehenden Ansprüche, **dadurch gekennzeichnet,** daß der zwischen dem Deckel (44) und der Bodenplatte (47) angeordnete Drehteller (48) mit der - abgedichtet durch die Bodenplatte (47) - hindurchgeführten Antriebswelle (49) eines weiteren Schwenkmotors (18) drehfest verbunden ist, wobei der Drehteller (48) eine oder mehrere mindestens der Dicke der Hubteller (52, 53) entsprechende Ausnehmungen (50, 51) aufweist, die in die Oberseite (97) des Drehtellers (48) eingearbeitet sind und deren Ausdehnung quer zur Rotationsachse (104) des Drehtellers (48) der Konfiguration der Hubteller (52, 53) entspricht, wobei im Bereich jeder Ausnehmung (50, 51) eine Bohrung (115, 116) vorgesehen ist, die der Aufnahme eines Zapfens (54, 55) dient, der mit dem in der Ausnehmung (50, 51) gehalten und geführten Hubteller (52, 53) verbunden ist.

13. Vorrichtung nach Anspruch 12, **dadurch gekennzeichnet,** daß die Bohrung (115, 116) im Drehteller (48) als Stufenbohrung ausgebildet ist und der Zapfen (54, 55) ein Kopfteil oder einen Kragen (117, 118) aufweist, an dem sich eine den Schaftteil des Zapfens (54, 55) umschließende Druckfeder (119, 120) abstützt, die andererseits an der kleinen Stufe der Bohrung (115, 116) anliegt und den zugehörigen Hubteller (52, 53) in die entsprechende Ausnehmung (50, 51) im Drehteller (48) zieht.

## Claims

1. Coating apparatus having a coating chamber (21) and a cathode as a coating source (38), having a device for the transfer of substantially flat workpieces (103) into and out of the evacuable coating chamber (21) which is formed by a lid (44) and a base plate (47) extending in a parallel plane to the lid and an annular side part (20) connecting the two parts (44, 47) in a compression-proof manner and holding said two parts at a distance, and having a rotary table rotatably supported in the coating chamber (21) for transporting the workpieces (103) from a transfer opening (90) in the lid (44) of the coating chamber (21) to the coating source (38) and back, characterized by a loading apparatus (22) having one or more lid-shaped workpiece carriers (67, 68), by means of which the workpieces (103) held underneath the workpiece carriers (67, 68) are movable into a position adjacent to the transfer opening (90) of the coating chamber (21), from which position the transfer opening (90) is closable from above by means of the workpiece carrier (67, 68) and from below by means of a lifting table (52, 53), the lifting table being held and guided on the rotatably supported rotary table (48), and the workpiece carrier (67, 68) being pressable by means of a lifting cylinder (69, 70) supported on the loading apparatus (22) and the lifting table (52, 53) being pressable by means of a fixed lifting apparatus against the lid (44), the transfer opening (90) when closed on both sides being evacuable for inward and outward transfer.

2. Apparatus according to claim 1, characterized in that the transfer opening (90) in the lid (44) of the coating chamber (21) is at a distance (A) from the axis of rotation (104) of the rotary table (48) which corresponds to the distance (B) from the axis of rotation (104) to a further opening in the lid (44) of the coating chamber (21), above which the coating source (38) is disposed.

3. Apparatus according to claims 1 and 2, characterized in that the transfer opening (90) in the lid (44) of the coating chamber (21) is delimited by an inward transfer ring (63), which is disposed in a fixed manner on the lid (44) and has a stepped bore whose large step (83) is provided on the side facing the workpiece carrier (67, 68), the workpiece carrier (67, 68) having a flange-like circumferential edge portion (81, 82) which is so dimensioned that it may be placed onto the step (83) of the inward transfer ring (63) for closure of the transfer opening (90).

4. Apparatus according to the preceding claims, characterized in that the inward transfer ring (63) disposed in a fixed manner on the lid (44) of the coating chamber (21) has one or more radially extending channels (92) corresponding with further ducts or bores (91) which are connected to a pump suction line or a pump connection (62), the channels (92) opening out into a region of the transfer opening (90) of the inward transfer ring (63) which, when the workpiece carrier (67, 68) is placed onto and the lifting plate (52, 53) is pressed against the inward transfer ring (63), is formed by a space or gap formed by the workpiece carrier and the applied lifting table.

5. Apparatus according to one or more of the preceding claims, characterized in that the loading apparatus (22) has a swivel motor (64) which is disposed in a fixed manner on the top of the lid (44) of the coating chamber (21) and whose output shaft (65) is connected non-rotatably to a swivel arm (66) extending at right angles to the output shaft (65), with there being disposed on at least one swivel arm end a lifting motor or lifting cylinder (69, 70), whose working shaft or piston rod (108, 109) extends perpendicular to the plane of the coating chamber (21) and is operationally connected to the workpiece carrier (67, 68).

6. Apparatus according to one or more of the preceding claims, characterized in that the lifting apparatus (58, 59) disposed on the base plate (47) of the coating chamber (21) comprises a magnetically, hydraulically or pneumatically operated motor which drives a piston rod or a plunger (56, 57), which is conveyed sealingly through the base plate (47) and during its outward travel acts upon a journal (54, 55) which is part of the lifting plate (52, 53) which may be lowered into a recess (50, 51) of the rotary table (48).

7. Apparatus according to one or more of the preceding claims, characterized in that the top (97) and the underside (110) of the rotary table (48) are plane-parallel to one another and extend at a distance (C, D) from the plane inner surface of the lid (44) and the base plate (47) respectively, with between the rotary table (48) and the lid (44) a transverse or sealing strip (111), which extends at right angles to the axis of rotation (104) of the rotary table (48) and whose thickness roughly corresponds to the distance (C) between the lid (44) and the top (97) of the rotary table (48), being disposed in a fixed manner on the inner surface of the lid (44), which strip divides the gap-like space left between rotary table (48) and lid (44) into two sector-shaped portions and substantially excludes an overflow of gases from one portion to the other.

8. Apparatus according to one or more of the preceding claims, characterized in that in the region of a cathode chamber (23) containing the cathode, between a target (39) and the rotary table (48), there is provided in the lid (44) of the coating chamber (21) an opening into which is inserted a ring or flange (45), through which cooling channels (46) pass and on which a collar-like mask (43) is fixed, the mask (43) having one or more radially inwardly extendable arms (112, 113) which form a common middle portion (114) holding a centring pin (99) which is extendable in the direction of the rotary table (48).

9. Apparatus according to claim 8, characterized in that the ring or flange (45) inserted into the lid (44) of the coating chamber (21) between the target (39) and the rotary table (48) has a screen (42), which substantially takes the form of a hollow cylinder and at least partially encloses the coating source (38).

10. Apparatus according to claim 8 or 9 in conjunction with claim 7, characterized in that the flange (45) inserted in the lid (44) of the coating chamber (21) is supported on or is screw-connected to the sealing strip (111) disposed between the rotary table (48) and the lid (44).

11. Apparatus according to one or more of claims 8 to 10, characterized in that one or more spacers (106, 107) are disposed between the lid (44) and the base plate (47), the flange (45) inserted into the lid (44) being supported and held by at least one of said spacers (106, 107).

12. Apparatus according to one or more of the preceding claims, characterized in that the rotary table (48) disposed between the lid (44) and the base plate (47) is non-rotatably connected to the drive shaft (49) - guided in a sealed manner through the base plate (47) - of a further swivel motor (18), the rotary table (48) having one or more recesses (50, 51) which correspond at least to the thickness of the lifting tables (52, 53) and are worked into the top (97) of the rotary table (48) and whose extension at right angles to the axis of rotation (104) of the rotary table (48) corresponds to the configuration of the lifting tables (52, 53), there being provided in the region of each recess (50, 51) a bore (115, 116) used to receive a journal (54, 55), which is connected to the lifting table (52, 53) held and guided in the recess (50, 51).

13. Apparatus according to claim 12, characterized in that the bore (115, 116) in the rotary table (48) takes the form of a stepped bore and the journal (54, 55) has a head part or collar (117, 118), on which a compression spring (119, 120) enclosing the shaft part of the journal (54, 55) is supported, said spring at its other end resting on the small step of the bore (115, 116) and drawing the associated lifting table (52, 53) into the corresponding recess (50, 51) in the rotary table (48).

## Revendications

1. Appareil de revêtement comprenant une chambre de revêtement (21) et une cathode en tant que source de revêtement (38), un dispositif de sas pour l'entrée/sortie d'articles sensiblement plats (103) dans la chambre de revêtement (21) susceptible d'être évacuée et constituée par un couvercle (44) et par une plaque de fond (47) qui s'étend dans un plan parallèle à ce couvercle et par une partie latérale de forme annulaire (20) qui relie le couvercle et le fond (44,47) de manière résistante à la pression et les maintient à distance l'un de l'autre, et l'appareil comprenant une platine tournante (48) montée dans la chambre de revêtement (21) pour le transport des articles (103) depuis une ouverture de sas (90) dans le couvercle (44) de la chambre de revêtement (21) jusqu'à la source de revêtement (38) et inversement, caractérisé en ce qu'il comprend des moyens de chargement (22) comprenant un ou plusieurs porte-articles en forme de couvercle (67,68) au moyen desquels les articles (103) tenus au-dessous des porte-articles (67,68) peuvent être amenés dans une position voisine de l'ouverture de sas (90) de la chambre de revêtement (21), à partir de laquelle l'ouverture de sas (90) peut être fermée par le haut au moyen du porte-article (67,68) et par le bas au moyen d'une platine de levage (52,53), la platine de levage étant retenue et guidée sur la platine tournante (48), et les porte-articles (67,68) pouvant être appliqués sous pression contre le couvercle (44) au moyen d'un cylindre de levage (69,70) qui s'appuie sur les moyens de chargement (22) et la platine de levage (52, 53) pouvant être appliquée sous pression contre le couvercle (44) au moyen d'un dispositif de levage (58,59) fixe, l'ouverture de sas (90) fermée des deux côtés pouvant être évacuée pour l'entrée/sortie à travers le sas.

2. Appareil selon la revendication 1, caractérisé en ce que l'ouverture de sas (90) dans le couvercle (44) de la chambre de revêtement (21) est située à une distance (A) de l'axe de rotation (104) de la platine tournante (48), qui correspond à la distance (B) entre l'axe de rotation (104) et une autre ouverture dans le couvercle (44) de la chambre de revêtement (21), au-dessus de laquelle est agencée la source de revêtement (38).

3. Appareil selon les revendications 1 et 2, caractérisé en ce que l'ouverture de sas (90) dans le couvercle (44) de la chambre de revêtement (21) est délimitée par un anneau de sas (63) agencé de manière fixe sur le couvercle (44), cet anneau comportant un perçage étagé dont le grand gradin (83) est prévu du côté dirigé vers le porte-article (67,68), le porte-article (67,68) comportant une partie de bordure périphérique en forme de bride (81,82) qui a une taille telle qu'elle peut être appliquée sur le gradin (83) de l'anneau de sas (63) pour fermer l'ouverture de sas (90).

4. Appareil selon les revendications précédentes, caractérisé en ce que l'anneau de sas (63) agencé fixement sur le couvercle (44) de la chambre de revêtement (21) comporte un ou plusieurs canaux radiaux (92) qui correspondent avec d'autres passages ou perçages (91) qui sont reliés à une conduite d'aspiration ou à un raccordement de pompe (62), les canaux (92) débouchant dans une région de l'ouverture de sas (90) de l'anneau de sas (62) qui est formée par un intervalle ou une fente constituée entre le porte-article et la platine de levage lorsque le porte-article (67,68) est appliqué sur l'anneau de sas (63) et la platine de levage (52,53) est appliquée sous pression.

5. Appareil selon l'une ou plusieurs des revendications précédentes, caractérisé en ce que les moyens de chargement (22) comprennent un moteur de pivotement (64) agencé fixement sur la face supérieure du couvercle (44) de la chambre de revêtement (21), l'arbre d'entraînement (65) dudit moteur étant relié solidairement en rotation à un arbre de pivotement (66) qui s'étend perpendiculairement à l'arbre d'entraînement (65), un moteur ou un cylindre de levage (69,70) étant agencé sur l'une au moins des extrémités du bras de pivotement, l'arbre moteur ou la tige de piston (108, 109) de ce moteur ou de ce cylindre s'étendant perpendiculairement au plan de la chambre de revêtement (21) et étant en liaison active avec le porte-article (67,68).

6. Appareil selon l'une ou plusieurs des revendications précédentes, caractérisé en ce que le dispositif de levage (58,59) agencé sur la plaque de fond (47) de la chambre de revêtement (21) comprend un moteur entraîné de façon magnétique, hydraulique ou pneumatique, lequel entraîne une tige de piston ou un poinçon (56,57) qui traverse de façon étanche la plaque de fond (47) et agit pendant sa montée sur un tenon (54,55) qui fait partie de la platine de levage (52,53) laquelle peut être abaissée dans un évidement (50,51) de la platine tournante (48).

7. Appareil selon l'une ou plusieurs des revendications précédentes, caractérisé en ce que la face supérieure (97) et la face inférieure (110) de la platine tournante (48) sont réalisées parallèle l'une à l'autre et s'étendent à distance (C, D) de la face intérieure plane du couvercle (44), respectivement de la plaque de fond (47), une barrette transversale ou d'étanchéité (111) qui s'étend perpendiculairement à l'axe de rotation (104) de la platine tournante (48) étant agencée entre la platine tournante (48) et le couvercle (44), l'épaisseur de cette barrette correspondant approximativement à la distance (C) entre le couvercle (44) et la face supérieure (97) de la platine (48), barrette qui est agencée en position fixe sur la face intérieure du couvercle (44) et divise l'espace en forme de fente qui reste entre la platine tournante (48) et le couvercle (44) en deux sections en forme de secteurs circulaires et exclut largement un écoulement des gaz depuis une section vers l'autre.

8. Appareil selon l'une ou plusieurs des revendications précédentes, caractérisé en ce que dans la région d'une chambre de cathode (23) qui contient la cathode, est prévue une ouverture dans le couvercle (44) de la chambre de revêtement (21 ) entre une cible (39) et la platine tournante (48), un anneau ou bride (45) traversé par des canaux de refroidissement (46) étant inséré dans ladite ouverture, un masque (43) en forme de collerette étant agencé de manière fixe sur ledit anneau, et le masque (43) comportant un ou plusieurs bras (112, 113) qui s'étendent radialement vers l'intérieur, et forment une section centrale commune (114), laquelle porte une tige de centrage (99) qui s'étend dans la direction de la platine tournante (48).

9. Appareil selon la revendication 8, caractérisé en ce que l'anneau ou bride (45) inséré dans le couvercle (44) de la chambre de revêtement (21) entre la cible (39) et la platine tournante (49) comporte un diaphragme (42), qui est réalisé essentiellement sous la forme d'un cylindre creux et qui entoure au moins partiellement la source de revêtement (38).

10. Appareil selon l'une ou l'autre des revendications 8 ou 9 prise en combinaison avec la revendication 7, caractérisé en ce que la bride (45) insérée dans le couvercle (44) de la chambre de revêtement (21) s'appuie sur la barrette d'étanchéité (111) agencée entre la platine tournante (48) et le couvercle (44), ou est vissée sur ladite barrette.

11. Appareil selon l'une ou plusieurs des revendications 8 à 10, caractérisé en ce qu'il est prévu entre le couvercle (44) et la plaque de fond (47) un ou plusieurs organes d'espacement (106, 107), la bride (45) insérée dans le couvercle (44) étant supportée et maintenue par l'un au moins de ces organes d'espacement (106, 107).

12. Appareil selon l'une ou plusieurs des revendications précédentes, caractérisé en ce que la platine tournante (48) agencée entre le couvercle (44) et la plaque de fond (47) est reliée solidairement en rotation à l'arbre d'entraînement (49) - qui traverse de manière étanche la plaque de fond (47) - d'un autre moteur de pivotement (18), la platine tournante (48) comportant un ou plusieurs évidements (50, 51) qui correspondent au moins à l'épaisseur de la platine de levage (52, 53), ces évidements étant ménagés dans la face supérieure (97) de la platine tournante (48) et leur extension transversalement à l'axe de rotation (104) de la platine tournante (48) correspondant à la configuration de la platine de levage (52, 53), un perçage (115, 116) étant prévu dans la région de chaque évidement (50, 51), perçage qui sert à recevoir un tenon (54, 55) qui est relié à la platine de levage (52, 53) maintenue et guidée dans l'évidement (50, 51).

13. Appareil selon la revendication 12, caractérisé en ce que le perçage (115, 116) dans la platine tournante (48) est réalisé sous la forme d'un perçage étagé, et en ce que le tenon (54, 55) présente une partie de tête ou une collerette (117, 118), sur laquelle s'appuie un ressort de compression (119, 120) qui entoure la tige du tenon (54, 55), ledit ressort s'appuyant par ailleurs sur le petit gradin du perçage (115, 116) et tirant la platine de levage associée (52, 53) dans l'évidement correspondant (50, 51) dans la platine tournante (48).
